Europäisches Patentamt

(19) European Patent Office

Office européen des brevets

(11) Publication number: **0 133 958**
**B1**

(12) **EUROPEAN PATENT SPECIFICATION**

(45) Date of publication of patent specification: **27.09.89**

(51) Int. Cl.⁴: **H 01 L 27/02**

(21) Application number: **84108860.2**

(22) Date of filing: **26.07.84**

(54) A masterslice semiconductor device.

(30) Priority: **26.08.83 JP 155005/83**

(43) Date of publication of application:
**13.03.85 Bulletin 85/11**

(45) Publication of the grant of the patent:
**27.09.89 Bulletin 89/39**

(84) Designated Contracting States:
**DE FR GB**

(56) References cited:
**EP-A-0 080 361**
**ELECTRONICS INTERNATIONAL, vol. 56, no. 3,**
**February 1983, pages 86,87, New York, US; C.**
**COHEN:"Gate array needs fewer gates for**
**RAM"**
**PATENTS ABSTRACTS OF JAPAN, vol. 7, no.**
**251 (E-209)(1396), November 8, 1983 & JP-A-58**
**139 446**

(73) Proprietor: **FUJITSU LIMITED**
**1015, Kamikodanaka Nakahara-ku**
**Kawasaki-shi Kanagawa 211 (JP)**

(72) Inventor: **Sato, Shinji**
**685-1-202, Kamiochiai**
**Atsugi-shi Kanagawa, 243 (JP)**
Inventor: **Goto, Gensuke**
**600-5-6-204, Kashiwagaya**
**Ebina-shi Kanagawa, 243-04 (JP)**

(74) Representative: **Seeger, Wolfgang, Dipl.-Phys.**
**SEEGER & SEEGER Patentanwälte & European**
**Patent Attorneys Georg-Hager-Strasse 40**
**D-8000 München 70 (DE)**

Courier Press, Leamington Spa, England.

## Description

### Background of the invention

The present invention relates to a semiconductor device of a large scale integration (LSI) and, more specifically relates to the improvement of a so-called masterslice semiconductor device, such as a gate array, fabricated with a large number of transistors arranged along both rows and columns of a semiconductor substrate.

Masterslice semiconductor technology is proposed as a means for providing custom-tailored large scale integrated semiconductor devices at a low manufacturing cost and in a short turnaround time. That is, a large number of transistors and resistors formed in a semiconductor substrate in advance are interconnected by the use of masks having wiring patterns necessary for realizing a functional circuit to meet each customer's specific requirements. In the masterslice semiconductor device, transistors are usually arranged so as to constitute a number of unit groups called basic cells having an identical pattern. An exemplary basic cell configuration and the circuit comprised of the basic cells are disclosed in the United States Patent 4,412,237, issued October 25, 1983.

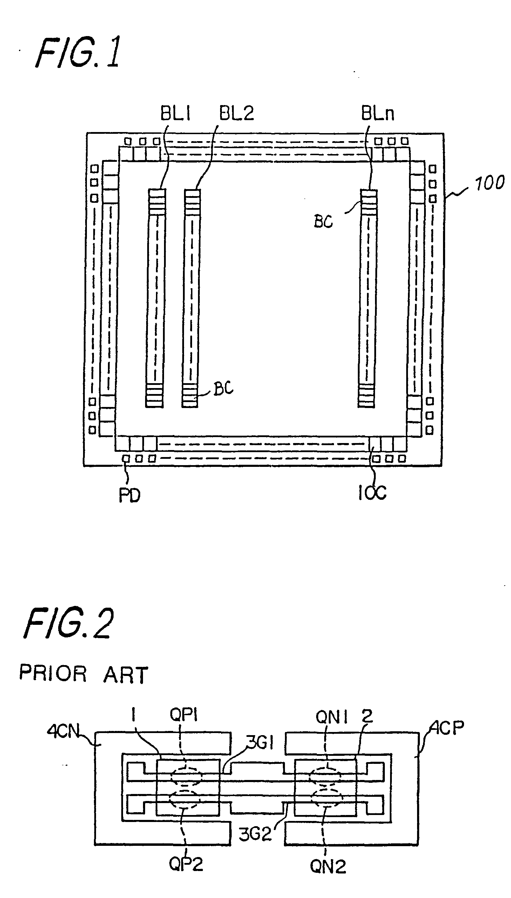

Fig. 1 is a plan view showing an exemplary bulk pattern of a gate array. As illustrated in Fig. 1, on a semiconductor substrate chip 100, the basic cells BC are arranged along the columns and constitute basic cell arrays $BL_1$, $BL_2$, ... $BL_n$. Each of the basic cells BC is, in general, comprised of at least a pair of p-channel and n-channel MIS (Metal Insulator Semiconductor) transistors (which will simply be referred to as p-channel and n-channel transistors hereinafter). The basic cell arrays are arranged with a specified space therebetween along the rows. At the periphery of the chip 100, there is a pad region which is allotted for a plurality of pads PD, each used as the terminal to the external circuit, and an input/output region which is allotted for the input/output cells IOC, each containing an input/output circuit. The space between each adjacent basic cell array is usually used for distributing the wiring lines interconnecting the basic cells located in the same basic cell array and/or the basic cells located in different basic cell arrays.

Fig. 2 is a plan view illustrating an exemplary bulk pattern of the conventional basic cell. In Fig. 2, the sources and drains of p-channel transistors $QP_1$ and $QP_2$ are formed in the p-type region 1, and the sources and drains of the n-channel transistors are formed in the n-type region 2. The polysilicon gate electrode $3G_1$, which extends along one of the gate channels in each of the p-type region 1 and the n-type region 2, forms a single common gate of the p-channel transistor $QP_1$ and n-channel transistor $QN_1$, while the polysilicon gate electrode $3G_2$, which extends along another gate channel in each of the p-type region 1 and n-type region 2, forms a single common gate of the p-channel transistor $QP_2$ and n-channel transistor $QN_2$. 4CP and 4Cn respectively designate a p-type contact region and a n-type contact region, which are used for keeping every portion of the semiconductor substrate chip at specified potential.

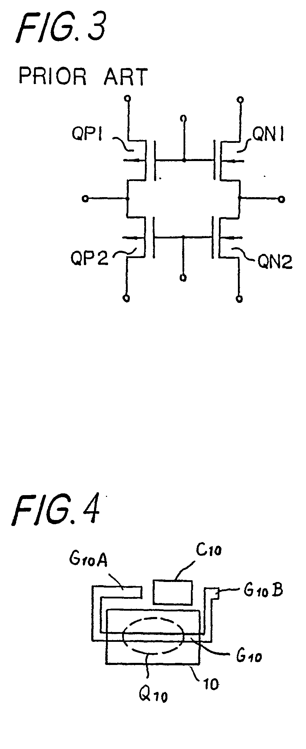

Fig. 3 is an equivalent circuit diagram of the circuit included in the basic cell shown in Fig. 2. The basic cell is comprised of a couple of p-channel transistors $QP_1$ and $QP_2$, and a couple of n-channel transistors $QN_1$ and $QN_2$.

A number of such basic cells as shown in Figs. 2 and 3 are disposed along the columns of a semiconductor chip, hence forming a plurality of arrays called basic cell arrays as shown in Fig. 1. The basic arrays are arranged one another with a specified space therebetween along the rows of the semiconductor substrate. Such basic cells are interconnected by use of double-layer aluminum metallization technology, then a desired LSI circuit network is completed.

In the masterslice semiconductor device, the LSI circuit network is formed of a number of elementary circuit blocks, in general, including a 2-input NAND gate, a 2-input NOR gate and/or a flip-flop circuit. Each of the elementary circuits is organized by using a single or a plurality of such basic cells shown in Figs. 2 and 3. The area occupied by the basic cells constituting each elementary circuit is referred to as a unit cell. However, when some kinds of unit cells, such as a RAM (Random Access Memory), a transmission gate circuit or a clocked gate circuit are constructed by using the basic cells as shown in Figs. 2 and 3, it is inevitable to leave one or more redundant transistors in the basic cells unused. For example, four of the basic cells as shown Fig. 2 are used to constitute a single 8-transistor RAM cell, however, only a half of total 16 transistors in the four basic cells are effectively utilized and the other half transistors are left unused and made inactive. As for a transmission gate circuit, two transmission gate circuits can be formed from one of the basic cell, but they can not operate independently of each other, accordingly, except for some special applications, one of the two transmission gates is redundant. In a clocked gate circuit composed from two basic cells, a half of total eight transistors is unused and made inactive. The occurrence of the redundant transistors reduces the integration density of the LSI circuit network on the masterslice semiconductor chip.

### Summary of the invention

It is, therefore, the primary object of the present invention to provide a masterslice which permits to construct various kinds of unit cells without leaving the redundant transistors unused in the basic cells.

It is another object of the present invention to provide a masterslice semiconductor device having a higher integration density of transistors when compared with that in the conventional masterslice semiconductor devices.

The above objects can be accomplished by the features of claim 1. The extension lines of the wiring lines pass through over the source or drain regions of other transistors arranged in line with the subject transistor. This structure of the terminal portion increases the variety of the layout of a connection to the gate electrode. Namely, the connecting point can be selected from several positions, and a number of wiring lines can be laid out over across the unselected positions. Therefore, it can be easily accomplished to connect the gate of a transistor to the source or drain regions of other transistors arranged in line with the MIS transistor, without the assistance of wiring lines distributed in the space between adjacent basic cell arrays (see Fig. 1). Thanks to the extended terminal portion of the gate electrode and the electrical independency of each transistor from others in a basic cell, the occurrence of the redundant transistors can be eliminated, accordingly effective integration density of transistors in a masterslice LSI semiconductor device can be substantially increased.

The present invention covers the configuration of a basic cell which comprises two pairs of p-channel and n-channel transistors accompanied by a couple of additional p-channel transistors and another couple of additional n-channel transistors, wherein the additional transistors in each of the couples are formed in parallel to each other and adjacently to the longitudinal ends of previous transistor pairs. With one of this basic cell, a 8-transistor RAM (Random Access Memory) cell can be organized, without originating any redundant transistors.

Further objects, features and advantages will appear more fully from the following preferred embodiments.

Brief description of the drawings

Fig. 1 is a plan view showing an exemplary bulk pattern of a gate array;

Fig. 2 is a plan view illustrating an exemplary bulk pattern of the conventional basic cell;

Fig. 3 is an equivalent circuit diagram of the circuit included in the basic cell shown in Fig. 2;

Fig. 4 is a plan view illustrating a bulk pattern of a fundamental basic cell structure according to the present invention;

Fig. 5(a) is a plan view illustrating a bulk pattern of a modified basic cell configuration according to the present invention;

Fig. 5(b) is a plan view illustrating a bulk pattern of another modified basic cell configuration according to the present invention;

Fig. 6 is a plan view illustrating a bulk pattern of further another modified basic cell configuration according to present invention;

Fig. 7 is an equivalent circuit diagram corresponding to the bulk pattern shown in Fig. 6;

Fig. 8 is a plan view illustrating a bulk pattern embodying a 2-input NAND gate circuit in the basic cell shown in Figs. 6 and 7;

Fig. 9 is an equivalent circuit diagram corresponding to the bulk pattern of the 2-input NAND gate circuit shown in Fig. 8;

Fig. 10 is a plan view for explaining advantages resulting from the layout of the basic cell according to the present invention;

Fig. 11 is a partial plan view illustrating the right hand side portion of a basic cell array comprising basic cells of the present invention;

Fig. 12 is a partial plan view illustrating the right hand side portion of a basic cell array comprising the conventional basic cells shown in Fig. 3;

Fig. 13 is a plan view illustrating a bulk pattern embodying a RAM cell by using the basic cell shown in Fig. 6;

Fig. 14 is an equivalent circuit diagram corresponding to the bulk pattern of the RAM cell shown in Fig. 13;

Fig. 15 is a plan view illustrating a bulk pattern embodying a transmission gate circuit in a basic cell of the present invention;

Fig. 16 is an equivalent circuit diagram corresponding to the bulk pattern of the transmission gate circuit formed in a basic cell as shown in Fig. 15;

Fig. 17 is a plan view illustrating a bulk pattern embodying a clocked gate circuit in a basic cell of the present invention; and

Fig. 18 is an equivalent circuit diagram corresponding to the bulk pattern of the clocked gate circuit shown in Fig. 18.

Preferred embodiment of the invention

Fig. 4 is a plan view illustrating a bulk pattern of a fundamental basic cell structure according to the present invention. Referring to Fig. 4, the gate electrode $G_{10}$ of the MIS transistor $Q_{10}$ whose source and drain occupy the p-type (or n-type) region 10 is extended along the periphery of the region 10 to form the terminal portion $G_{10}A$. The terminal portion $G_{10}A$ is aligned in parallel to the gate electrode $G_{10}$. Another terminal portion $G_{10}B$ is provided with a tab. In Fig. 4, the reference character $C_{10}$ designates a contact region for supplying the semiconductor substrate with a specified potential. A plurality of such basic cells are arranged in a line along the columns and constitute a basic cell array.

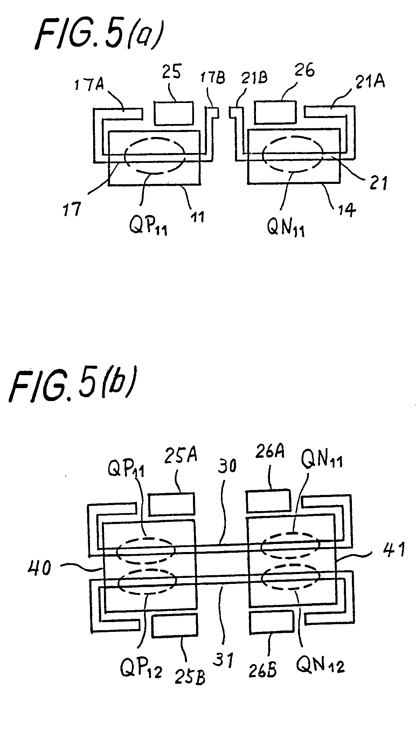

Fig. 5(a) is a plan view illustrating a bulk pattern of a modified basic cell configuration according to the present invention. The basic cell shown in Fig. 5(a) comprises a pair of p-channel transistor $QP_{11}$ and n-channel transistor $QN_{11}$. The source and drain of each of the p-channel transistor $QP_{11}$ and n-channel transistor $QN_{11}$ respectively occupy the p-type region 11 and the n-type region 14. In Fig. 5(a), the one end of the gate electrode 17 of the p-channel transistor $QP_{11}$ is extended along left side periphery of the p-type region 11 to the terminal portion 17A, while the one end of the gate electrode 21 of the n-channel transistor $QN_{11}$ is extended along right side periphery of the n-type region 14 to the terminal portion 21A. The other end of each of gate electrodes 17 and 21 respectively extend to the terminal portions 17B and 21B. The terminal portions 17B and 21B adjacently face each other and are provided with a tab each. The reference characters 25 and 26 respectively designate a n-type contact region and a p-type contact region, which contact regions are for the same purpose in the precedent embodiment.

Fig. 5(b) is a plan view illustrating a bulk pattern of another modified basic cell according to the present invention. The basic cell shown in Fig. 5(b) comprises two pairs of p-channel and n-channel transistors, the first one comprising a p-channel transistor $QP_{11}$ and an n-channel transistor $QN_{11}$, and the second one comprising a p-channel transistor $QP_{12}$ and an n-channel transistor $QN_{12}$, wherein the p-channel and n-channel transistors $QP_{11}$ and $QN_{11}$ have the common gate 30, while the p-channel and n-channel transistors $QP_{12}$ and $QN_{12}$ have the common gate 31, and the p-channel transistors $QP_{11}$ and $QP_{12}$ form a common source or drain in the p-type region 40, while the n-channel transistors $QN_{11}$ and $QN_{12}$ form a common source or drain in the n-type region 41. In Fig. 5(b), the reference characters 25A and 25B designate n-type contact regions, and the reference characters 26A and 26B designate p-type contact regions, which contact regions are for the same purposes in the precedent embodiments.

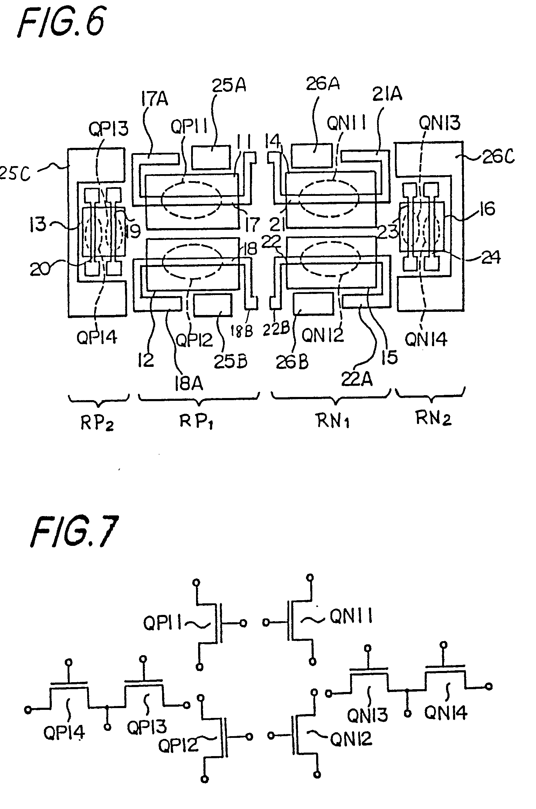

Fig. 6 is a plan view illustrating a bulk pattern of further another modified basic cell configuration according to the present invention. The basic cell shown by Fig. 6 is most practical one whose configuration is based on the basic cell shown by Fig. 5. That is, the basic cell comprising the first pair of p-channel transistor $QP_{11}$ and n-channel transistor $QN_{11}$ further comprises the second pair of p-channel transistor $QP_{12}$ and n-channel transistor $QN_{12}$, a couple of additional p-channel transistors $QP_{13}$ and $QP_{14}$, and another couple of additional transistors $QN_{13}$ and $QN_{14}$.

Each of the p-channel transistor $QP_{12}$ and n-channel transistor $QN_{12}$ is respectively formed adjacently to and in parallel to each of the p-channel transistor $QP_{11}$ and n-channel transistor $QN_{11}$ of the first pair. The sources and drains of the p-channel transistor $QP_{12}$ and n-channel transistor $QN_{12}$ respectively occupy the p-type transistor region 12 and n-type region 15. Like in the first pair, the one end of the gate electrode 18 of the p-channel transistor $QP_{12}$ is extended along the periphery of the p-type region 12 to the terminal portion 18A and the one end of the gate electrode 22 of the n-channel transistor $QN_{12}$ is extended along the periphery of the n-type region 15 to the terminal portion 22A, and also, both the other ends of the gate electrodes 18 and 22 are respectively extended to the terminal portions 18B and 22B, which face each other and are provided with a tab each. In Fig. 6, the reference characters 25A and 25B indicate n-type contact regions and 26A and 26B indicate p-type contact regions provided for supplying every portion of the semiconductor substrate with each specified potential.

The additional p-channel transistors $QP_{13}$ and $QP_{14}$ are formed adjacently to each other, whose sources or drains occupying the p-type transistor region 13 form a single common source or drain. The respective gate electrodes 19 and 20 of the additional p-channel transistors $QP_{13}$ and $QP_{14}$ are parallel to each other and perpendicular to the longitudinal directions of both of the first and the second transistor pairs, one comprising p-channel and n-channel transistors $QP_{11}$ and another comprising p-channel transistor $QP_{12}$ and n-channel transistor $QN_{12}$. In Fig. 6, the reference characters 25C and 26C respectively indicate an n-type contact region and a p-type contact region, which regions are provided for the same purpose as the contact regions 25A, 25B, 26A and 26B. The reference characters $RP_1$ and $RP_2$ respectively designate the first and the second p-channel transistor regions, and $RN_1$ and $RN_2$ respectively designate the first and the second n-channel transistor regions. The positions of the additional p-channel transistors $QP_{13}$ and $QP_{14}$ and the additional n-channel transistors $QN_{13}$ and $QN_{14}$ with respect to the transistor pairs may be interchanged, on condition that the conduction types of the contact region 25C and 26C may be also interchanged.

Fig. 7 is an equivalent circuit diagram corresponding to the bulk pattern shown in Fig. 6.

The differences between the basic cell shown in Figs. 6 and 7 and the conventional basic cell as shown in Figs. 2 and 3 are as follows: 1) in the basic cell shown in Figs. 6 and 7, the p-channel transistors $QP_{11}$ and $QP_{12}$, and n-channel transistors $QN_{11}$ and $QN_{12}$ are all formed to be electrically independent form the others, i.e. the p-channel and n-channel transistors in a basic cell have neither common gates nor common sources or drains; 2) each of the gate electrodes of the transistors $QP_{11}$, $QP_{12}$, $QN_{11}$ and $QN_{12}$ is extended along the periphery of respective p-type or n-type region to the respective terminal portions 17A, 18A, 21A and 22A formed in parallel to respective gate electrodes 17, 18, 21 and 22; 3) the second p-channel region $RP_2$ comprising a couple of additional p-channel transistors is provided adjacently to the first p-channel transistor region $RP_1$, and the second n-channel transistor region $RN_2$ comprising another couple of additional n-channel transistors is provided adjacently to the first n-channel transistor region $RN_1$.

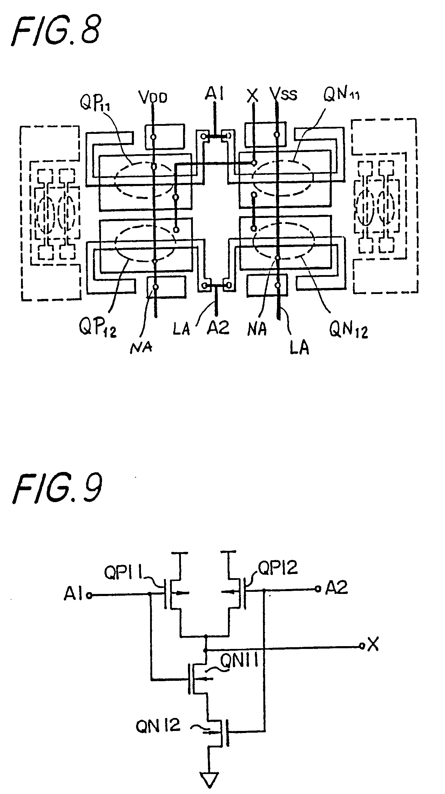

Fig. 8 is a plan view illustrating a bulk pattern embodying a 2-input NAND gate circuit formed in the basic cell shown in Figs. 6 and 7, and Fig. 9 is an equivalent circuit diagram of the 2-input NAND gate circuit. As shown in Fig. 8, the NAND gate circuit is comprised of the p-channel transistors $QP_{11}$ and $QP_{12}$ and n-channel transistors $QN_{11}$ and $QN_{12}$ in a single basic cell of the present invention. Each of the wiring lines laid on the basic cell in order for interconnecting the transistors in the basic cell has contacts with the semiconductor substrate at the position indicated by the small circles NA. For the interconnection in a masterslice, so-called double-layer aluminum metallization technology is applicable. Since the wiring lines in Fig. 8 have no cross over point with each other, the wiring can be accomplished with the use of wiring lines fabricated from the first aluminum layer. Each of the wiring lines are indicated by thick solid lines NA. In Fig. 8, the reference characters $A_1$ and $A_2$ denote input

signals, respectively, X denotes output signals, and $V_{DD}$ and $V_{SS}$ represent the lines supplied with positive potential and negative potential, respectively. The portions with no denotation should be referred to Fig. 6.

The areas occupied by the additional transistors and corresponding contact regions (both indicated by dotted lines) in Fig. 8 are not used for constituting the NAND gate circuit, so they can be utilized for distributing wiring lines as in the conventional masterslice semiconductor device.

As described above, the basic cell according to the present invention can be used as the conventional basic cell as shown in Fig. 3, however, further advantages provided by the basic cell of the present invention will be described more fully in the following.

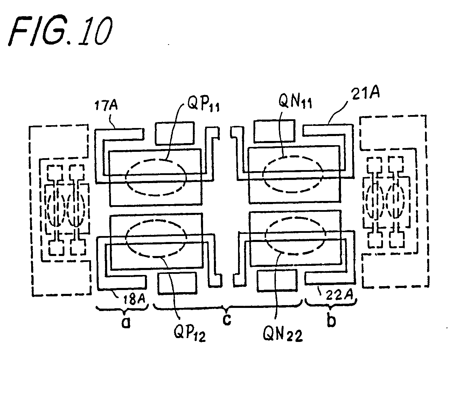

Let's note the basic cell of the present invention by dividing it into three regions (a), (b) and (c) as shown in Fig. 10, which is a reproduction of the bulk pattern of the basic cell shown in Fig. 6. In the region (a), the terminal portions 17A and 18A and the source and drain regions of the p-channel transistors $QP_{11}$ and $QP_{12}$ of every basic cells are regularly disposed through out the basic cell array. And in the region (b), the terminal portions 21A and 22A and the source and drain regions of the n-channel transistors $QN_{11}$ and $QN_{12}$ of every basic cell are regularly disposed throughout the basic cell array. This feature facilitates the construction of a large scale unit cell within a basic cell array.

An example of a large scale unit cell is one organized by interconnecting small scale unit cells such as 2-input NAND gate circuit and 2-input NOR gate circuit with use of aluminum wiring lines, wherein each of the small scale unit cells is formed from a basic cell within a basic cell array. Such small scale unit cell is referred to as sub-block, hereinafter. The number of interconnecting lines among the small scale unit cells increases as the range of a large scale unit cell expands.

Referring back to Figs. 2 and 3, in the conventional basic cell, the interconnection between the sources or drains of transistors each being in different basic cells must be selected from plural channels of straight wiring lines passing through the relevant sources or drains. However, the contact point of a wiring line for the gate electrode of the transistors $QP_1$, $QP_2$, $QN_1$ and $QN_2$ are only two; i.e. the tabs at both ends of the gate electrode with respect to each transistor. Furthermore, because the tabs are not arranged on a line passing through over the source or drain regions of any transistors in the basic cell array, therefore, the interconnection between a gate electrode and a source or drain region cannot be straight, and they must be folded.

As the result of the restrictions mainly relating to the connections to the gate electrodes, a number of the channels of wiring lines in the region between adjacent basic cell arrays should be consumed for constituting a large scale unit cell, and the channels allotted for interconnection among unit cells are decreased. In other word, the scale of a unit cell, that is, the degree of the complexity of a circuit in a unit cell, is restricted by the number of the wiring channels available for interconnecting unit cells.

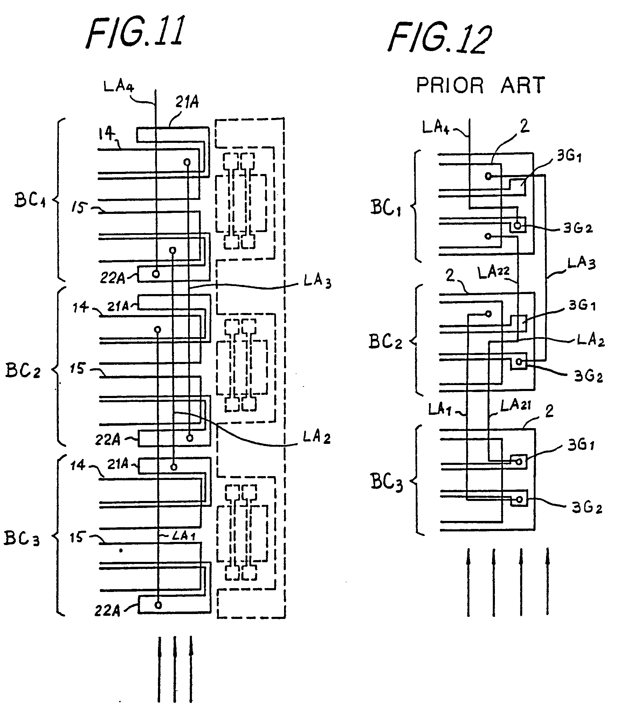

On the other hand, in the basic cell of the present invention, a sub-block such as 2-input NAND gate circuit or 2-input NOR gate circuit can be formed by distributing the wiring lines within the region (c) of the basic cell, as shown in Figs. 8 and 10, and the interconnecting lines among neighboring sub-blocks can also be laid in the region (c). For a number of interconnections ranging over a large scale unit cell, the wiring channels are also available in the regions (a) and/ or (b). That is, as already mentioned above, a number of straight wiring lines laid in the region (a) or (b) can directly interconnect the gates and/ or sources or drains of any transistors they pass through over. Thanks to the straight interconnections in the regions (a) and (b), the number of wiring channels along the columns is decreased compared with the wiring channels in an equivalent unit cell comprising the conventional basic cells as shown in Fig. 3. This is because, in the unit cell comprising conventional basic cells, interconnection by a straight wiring line is seldom and almost all wiring lines must have a bent shape; i.e., the wiring line must have interposition of a fraction directing along the rows, and the both fractions directing along the columns are not always in the same channel. This situation will be explained more with reference to Figs. 11 and 12.

Figs. 11 and 12 are both partial plan views illustrating right side portions of each of the basic cell arrays composed from basic cells of the present invention (Fig. 11) and the basic cell array composed from the conventional basic cells (Fig. 12). In Figs. 11 and 12, each of the arrow-headed lines indicates each wiring channel along the columns. The number of the channels is three in Fig. 11, while it is four in Fig. 12. As mentioned above, in the basic cell array comprising the conventional basic cell, each wiring line interconnecting a gate electrode and a source or drain region cannot help having a bent shape, as shown in Fig. 12. This results in the case of the wiring line $LA_2$ between the source or drain region 2 in the basic cell $BC_1$ and the gate electrode $3G_1$ in the basic cell $BC_3$, for example, wherein the wiring line $LA_2$ comprising the segments $LA_{21}$ and $LA_{22}$ occupies two channels to itself. As a result, the number of wiring channels becomes larger than that of the necessary interconnecting lines. On the contrary, as shown in Fig. 11, the straight interconnecting line structure provided in the basic cells of the present invention requires three wiring channels just equal to the number of interconnecting lines.

The basic cells according to the present invention have a larger dimension along the columns than that of the conventional basic cells, because each of the transistors in the basic cell is formed electrically independent from others. The reason for the larger dimension of the basic cells of the present invention is due to that a region for the source and drain is provided for each of the transistors in the basic cell, and not because the extended structure of the gate electrode. Therefore, if the circuits in all unit cells is a masterslice semiconductor device comprise plural couples of transistors, each of the couples having a single common source or drain, like the 2-input NAND gate circuit shown in Figs. 8 and 9, the integration density of transistors on a semiconductor substrate can be the same as that in the prior art, even the advantage of the extended structure of gate electrode is maintained.

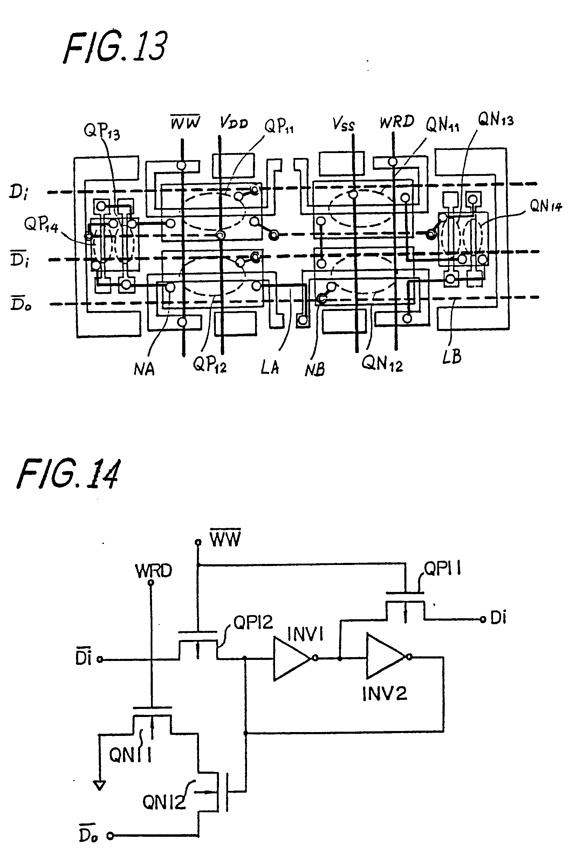

Fig. 13 is a plan view illustrating a bulk pattern embodying a RAM cell by using the basic cell shown in Fig. 6, and Fig. 14 is an equivalent circuit diagram corresponding to the bulk pattern of the RAM cell shown in Fig. 13. In Fig. 13, the wiring lines LA (indicated by thick solid lines) fabricated from the first layer of double-layer aluminum metallization have contacts with the semiconductor substrate at each point indicated by small circle, and connected to the wiring lines LB (indicated by thick dotted lines) fabricated from the second layer of double-layer aluminum metallization at each point indicated by doubled-circle via a through-hole in the insulating layer therebetween. In Figs. 13 and 14, reference characters Di, Di and Do respectively denote input signals, inverted input signals and inverted output signals, WRD and WW respectively indicate the word line of the read-out and the word line for the write-in, and $V_{DD}$ and $V_{SS}$ represent the lines respectively supplied with positive potential and negative potential. The inverter $INV_1$ in Fig. 14 is comprised of the additional transistors $QP_{13}$ and $QN_{13}$ in Fig. 13, and $INV_2$ in Fig. 14 is comprised of the additional transistors $QP_{14}$ and $QN_{14}$ in Fig. 13. As is obvious in Fig. 13, the RAM cell can be formed in a single basic cell according to the present invention, without leaving any redundant transistors.

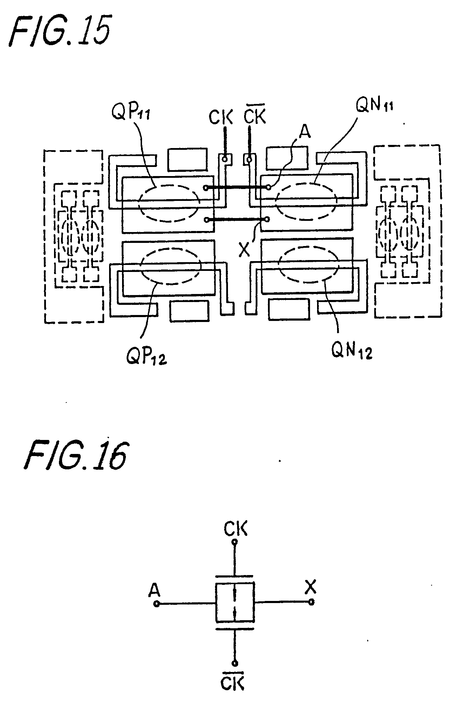

Fig. 15 is a plan view illustrating a bulk pattern embodying a transmission gate circuit by using the basic cell, like shown in Fig. 6, of the present invention and Fig. 16 is an equivalent circuit diagram corresponding to the bulk pattern of the transmission gate circuit formed in the basic cell shown in Fig. 15. In Figs. 15 and 16, the reference characters A, X, CK and CK denote input signals, output signals, clock signals and inverted clock signals, respectively. As shown in Fig. 15, a transmission gate circuit is formed from the p-channel transistor $QP_{11}$ and n-channel transistor $QN_{11}$, for example. By employing the p-channel transistor $QP_{12}$ and n-channel transistor $QN_{12}$, another transmission gate circuit can be formed. Both transmission gate circuits formed in the single basic cell can be operated independently each other, being different from those formed in the conventional basic cell.

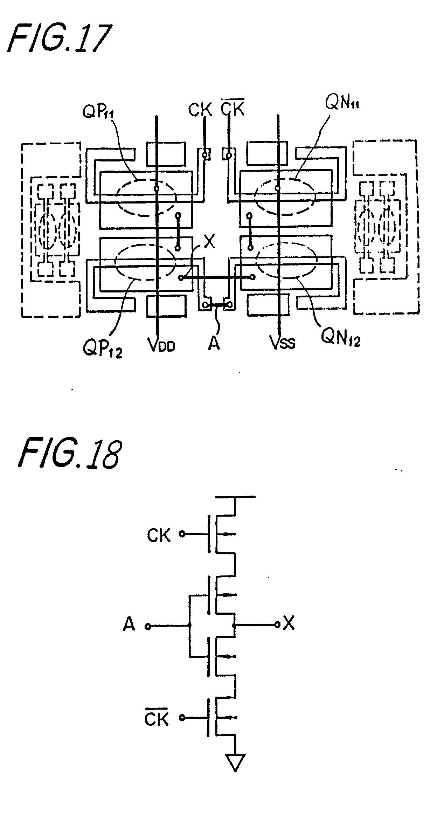

Fig. 17 is a plan view illustrating a bulk pattern embodying a clocked gate circuit as shown by the equivalent circuit diagram in Fig. 18. In Figs. 17 and 18, each of the reference characters designates like or corresponding part in the precedent figures. As shown in Fig. 17, the clocked gate circuit can be formed by use of a single basic cell, in contrast to the necessity of two conventional basic cells as shown in Fig. 3 in the prior art masterslice semiconductor device accompanying redundant transistors.

The many features and advantages of the present invention are apparent from the detailed description, but it will be recognized by those skilled in the art that modifications and variations may occur within the spirit and scope of the present invention. For example, the material for the gate electrode is not limited to polysilicon but may be another one, such as a silicide of a metal of high melting point. And also, the entire region occupied by the additional transistors in any basic cell arrays can be used as the wiring region as in the prior art. Furthermore, along rows, the arrangement of the p-channel and n-channel transistors constituting the transistor pair in any basic cell of the present invention may be optional among basic cell arrays, and the arrangement of the additional p-channel and n-channel transistors with respect to the transistor pair or pairs may also be optional, provided that the regularity of the arrangements are kept within each basic cell array. For instance, in a basic cell array, all of the p-channel transistors occupy the left-hand side positions against n-channel transistors, while, in any of the other basic cell arrays, vice versa.

**Claims**

1. A masterslice semiconductor device having a plurality of basic cells arranged in line, and a plurality of wirings for interconnecting said basic cells, each of said basic cells comprising a MIS (Metal Insulator Semiconductor) transistor having a gate electrode, a source region and a drain region, characterized in that said gate electrode extends along the periphery of said source or drain region to at least one terminal portion located adjacently said source (11) or drain (12) region and aligned in parallel to said gate electrode such that a plurality of connecting points (17A, 17B) can be selected from several positions, each of said connecting points being capable of being connected to said source region (11) or drain region (12) of one of the other basic cells via one of said wirings.

2. A masterslice semiconductor device as set forth in claim 1, wherein the other end of the gate electrode is provided with a tab for the connection to a wiring line.

3. A masterslice semiconductor device as set forth in claim 1, or 2, wherein said basic cell includes a pair of p-channel and n-channel transistors formed adjacently to each other, and the gates of said p-channel and n-channel MIS transistors are aligned with each other along the rows.

4. A masterslice semiconductor device as set forth in claim 3, said basic cell further comprises:

a second pair of p-channel and n-channel MIS transistors (RP$_2$, RN$_2$) each respectively formed adjacently to and in parallel to said p-channel and n-channel transistors of the first pair;

a couple of additional p-channel MIS transistors formed in parallel to each other and adjacently to the longitudinal ends of said first and second pairs;

a couple of additional n-channel MIS transistors formed in parallel to each other and adjacently to the other longitudinal ends of both first and second pairs, wherein the gates of said additional p-channel and n-channel MIS transistors are extended perpendicularly to the gates of said p-channel and n-channel MIS transistors of both first and second pairs.

5. A masterslice semiconductor device as set forth in claim 3 or 4, wherein. at an opposite end to said terminal portion of the gate electrodes of each said p-channel and n-channel MIS transistors in each pair is provided with a tab facing each other.

## Patentansprüche

1. Masterslice-Halbleitervorrichtung mit einer Vielzahl von Basiszellen, die in einer Reihe angeordnet sind, und einer Vielzahl von Verdrahtungen zum Zwischenverbinden der genannten Basiszellen, von denen jede Basiszelle einen MIS-(Metall-Isolator-Halbleiter)-Transistor umfaßt, der eine Gateelektrode, einen Sourcebereich und einen Drainbereich hat, dadurch gekennzeichnet, daß die genannte Gateelektrode sich längs der Peripherie des genannten Source- oder Drain-Bereichs zu wenigstens einem Anschlußabschnitt erstreckt, der neben dem genannten Source-(11) oder Drain-(12)-Bereich angeordnet und parallel zu der genannten Gateelektrode so ausgerichtet ist, daß eine Vielzahl von Verbindungspunkten (17A, 17B) von verschiedenen Positionen ausgewählt werden kann, von denen jeder Verbindungspunkt mit dem genannten Source-Bereich (11) oder Drain-Bereich (12) von einer der anderen Basiszellen über die genannten Verdrahtungen verbunden werden kann.

2. Masterslice-Halbleitervorrichtung nach Anspruch 1, bei der das andere Ende der Gateelektrode mit einem Abgriff zum Verbinden mit einer Verdrahtungsleitung versehen ist.

3. Masterslice-Halbleitervorrichtung nach Anspruch 1 oder 2, bei der die genannte Basiszelle ein Paar von p-Kanal- und n-Kanal-Transistoren umfaßt, die nebeneinander gebildet sind, und die Gates der genannten p-Kanal- und n-Kanal-MIS-Transistoren miteinander längs den Reihen ausgerichtet sind.

4. Masterslice-Halbleitervorrichtung nach Anspruch 3, bei der die genannte Basiszelle ferner umfaßt:

ein zweites Paar von p-Kanal und n-Kanal-MIS-Transistoren (RP2, RN2), die jeweils neben den und parallel zu den genannten p-Kanal und n-Kanal-Transistoren des ersten Paares gebildet sind;

ein Paar von zusätzlichen p-Kanal-MIS-Transistoren, die parallel zueinander und neben den Längsenden der genannten ersten und zweiten Paaren gebildet sind;

ein Paar von zusätzlichen n-Kanal-MIS-Transistoren, die parallel zueinander und neben den anderen Längsenden sowohl des ersten als auch des zweiten Paares angeordnet sind, wobei die Gates der zusätzlichen p-Kanal- und n-Kanal-MIS-Transistoren sich senkrecht zu den Gates der genannten p-Kanal- und n-Kanal-MIS-Transistoren sowohl des ersten als auch des zweiten Paares erstrecken.

5. Masterslice-Halbleitervorrichtung nach Anspruch 3, oder 4, bei der, an einem dem genannten Anschlußabschnitt der Gateelektroden entgegengesetzten Ende von jedem der genannten p-Kanal- und n-Kanal-MIS-Transistoren, jedes Paar einander zugewandte Abgriffe aufweist.

## Revendications

1. Dispositif semiconducteur du type à "matrice standard" ou "master-slice" possédant plusieurs cellules de base disposées en ligne et plusieurs câblages servant à interconnecter lesdites cellules de base, chacune desdites cellules de base comprenant un transistor MIS (métal-isolant-semiconducteur) qui possède une électrode de grille, une région de source et une région de drain, caractérisé en ce que ladite électrode de grille s'étend le long de la périphérie de ladite région de source ou de drain jusqu'à au moins une partie de borne placée de manière adjacente à ladite région de source (11) ou de drain (12) et alignée parallèlement à ladite électrode de grille de sorte que plusieurs points de connexion (17A, 17B) peuvent être sélectionnés depuis plusieurs positions, chacun desdits points de connexion étant susceptible d'être connectée à ladite région de source (11) ou région de drain (12) de l'une des autres cellules de base par l'intermédiaire de l'un desdits câblages.

2. Dispositif semiconducteur du type masterslice selon la revendication 1, où l'autre extrémité de l'électrode de grille est dotée d'une patte destinée à être connectée à une ligne de câblage.

3. Dispositif semiconducteur du type masterslice selon la revendication 1 ou 2, où ladite cellule de base comporte une paire de transistors à canal p et à canal n formés de manière à être adjacents l'un à l'autre, et les grilles desdits transistors MIS à canal p et à canal n sont alignées l'une avec l'autre le long des rangées.

4. Dispositif semiconducteur du type masterslice selon la revendication 3, ladite cellule de base comprenant en outre:

une deuxième paire de transistors MIS à canal p et à canal n (RP$_2$, RN$_2$) qui sont chacun respectivement formés de manière adjacente et parallèle auxdits transistors à canal p et à canal n de la première paire;

un couple de transistors MIS à canal p supplémentaires formés parallèlement l'un à l'autre et de manière adjacente aux extrémités longitudinales desdites première et deuxième paires;

un couple de transistors MIS à canal n supplémentaires formés parallèlement l'un à l'autre et de manière adjacente aux autres extrémités longitudinales desdites première et deuxième paires;

où les grilles desdits transistors MIS à canal p et à canal n supplémentaires s'étendent perpendiculairement aux grilles desdits transistors MIS à canal p et à canal n des première et deuxième paires.

5. Dispositif semiconducteur du type master-slice selon la revendication 3 ou 4, où à une extrémité opposée à ladite partie de borne des électrodes de grille de chacun desdits transistors MIS à canal p et à canal n chaque paire est dotée d'une patte, les pattes étant en regard l'une de l'autre.

# FIG.1

# FIG.2

PRIOR ART

1

# FIG. 3

PRIOR ART

QP1 QN1

QP2 QN2

# FIG. 4

$G_{10}A$ $C_{10}$

$G_{10}B$

$G_{10}$

$Q_{10}$ 10

## FIG.5(a)

## FIG.5(b)

EP 0 133 958 B1

## FIG.6

## FIG.7

4

## FIG.8

## FIG.9

# FIG.10

# FIG.11

# FIG.12

## FIG.13

## FIG.14

8

*FIG.15*

*FIG.16*

*FIG.17*

*FIG.18*